# FASCICULE DE BREVET EUROPEEN

(11) **EP 0 359 680 B1**
(45) Date de publication et mention de la délivrance du brevet: **29.12.1993**
(21) Numéro de dépôt: 89420332.2
(22) Date de dépôt: 11.09.1989
(51) Int. Cl.: H01L 27/02, H02H 11/00

(54) **Diode active intégrable**
Integrierbare, aktive Diode
Integretable active diode

(30) Priorité: 14.09.1988 FR 8812297
(43) Date de publication de la demande: 21.03.1990
(73) Titulaire: SGS-THOMSON MICROELECTRONICS S.A., 94250 Gentilly (FR)
(72) Inventeur: Pavlin, Antoine, F-13100 Aix en Provence (FR)
(74) Mandataire: de Beaumont, Michel

(56) Documents cités:
- EP-A- 0 236 200
- US-A- 4 303 958

## Description

La présente invention concerne un dispositif de protection contre des tensions inverses d'un circuit logique ; plus particulièrement, elle concerne un tel dispositif de protection de circuit logique dans le cas d'une structure mixte comprenant une partie logique et une partie de puissance du type à transistors MOS verticaux.

Le document US-A-4 303 958 décrit une structure mixte avec une diode active de protection du type revendiqué pour protéger une partie de puissance contre des tensions inverses, une partie logique étant protégée par l'utilisation d'une résistance série.

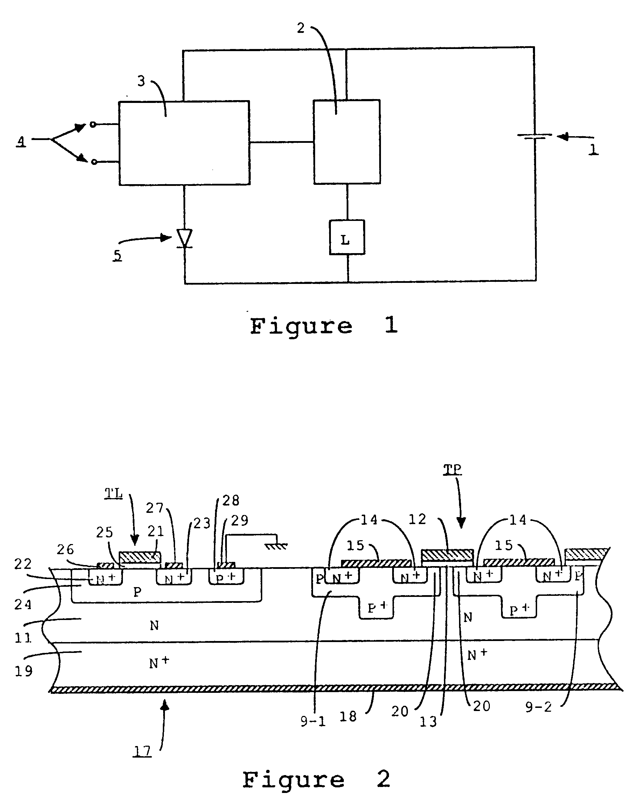

La figure 1 représente un schéma électrique comprenant une source de tension 1, par exemple la batterie d'une automobile, une partie de commutation de puissance 2 et une partie logique 3. La partie de commutation de puissance 2 permet d'alimenter une charge L. La partie logique 3 est pourvue d'entrées externes 4. Une diode zener, non représentée sur la figure, est généralement montée en parallèle de la source de tension. Cette diode zener permet d'écrêter la tension quand la source de tension fournit une alimentation en sens direct.

La protection du circuit logique 3 contre les tensions inverses doit être assurée par une diode 5. Cette diode est extérieure à la partie logique 3. Il serait très avantageux que la diode 5 fasse partie du même circuit intégré que la partie logique 3.

La figure 2 représente, en coupe un exemple de structure mixte classique dans laquelle la partie de puissance est représentée de façon schématique par une cellule d'un transistor MOS de puissance vertical de type diffusé (VDMOS) TP et la partie logique par un transistor MOS TL.

La structure est réalisée dans un substrat 11 d'un premier type de conductivité, par exemple de type N. Une cellule d'un transistor MOS de puissance TP comprend une région 9-1, 9-2 constituée par des diffusions d'un deuxième type de conductivité, par exemple de type P. Dans chaque région 9-1, 9-2 sont réalisées deux diffusions 14 de type N⁺ qui constituent la source du transistor de puissance. Les deux diffusions 14 sont connectées entre elles par une couche conductrice 15 qui est par exemple réalisée en aluminium. Les bords latéraux des régions 9-1, 9-2 constituent une région de canal 20 du transistor de puissance.

Chaque cellule d'un transistor MOS de puissance TP comprend une grille 12 formée par une couche de silicium polycristallin. Cette grille 12 est séparée du substrat 11 par une couche d'oxyde 13.

La face arrière 17 du substrat 11 comprend une couche surdopée 19 revêtue d'une métallisation de drain 18.

Le transistor MOS TL de la partie logique est formé dans un caisson 24 de type P. Ce caisson 24 comporte deux diffusions de type N⁺, une première diffusion constituant la source 22 et la seconde diffusion constituant le drain 23 du transistor TL. Ce transistor comprend une grille 21 constituée par une couche de silicium polycristallin. La grille 21 est séparée du caisson 24 par une couche d'oxyde 25. Les diffusions constituant la source 22 et le drain 23 sont chacune connectée à une ligne conductrice désignée par 26, 27, respectivement. Ces lignes conductrices 26, 27 sont par exemple réalisées en aluminium.

De façon classique, on prévoit dans le caisson 24 une zone 28 de type P⁺ connectée à une couche conductrice 29. La zone 28 et la couche conductrice 29 permettent la mise à la masse du caisson 24.

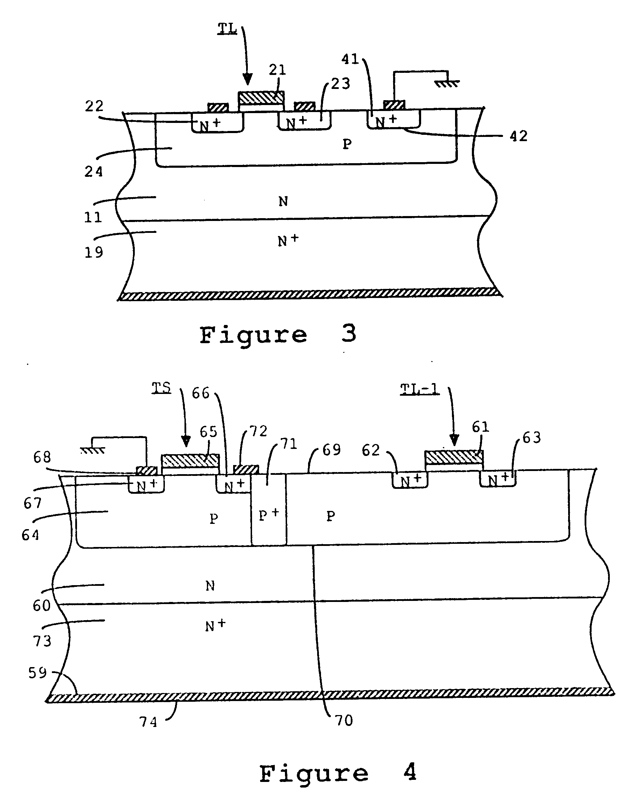

Pour réaliser une diode de protection intégrée de circuit logique dans une structure du type de celle de la figure 2, on pourrait envisager la solution représentée sur la figure 3.

On retrouve sur la figure 3 le transistor logique TL formé dans un caisson 24 qui comprend une diffusion constituant la source 22 et une diffusion constituant le drain 23 du transistor. Le transistor comprend également une grille 21.

Dans cette structure, la zone 28 représentée sur la figure 2, dont le dopage élevé était de type P⁺, est remplacée par une zone 41 qui a un dopage élevé de type N⁺. Cette structure présente ainsi une diode 42 au niveau de la jonction entre le caisson 24, de type P, et la zone 41.

Cette diode 42 assure la protection de la partie logique contre des tensions inverses. Cependant, cette configuration présente plusieurs inconvénients.

Tout d'abord, le niveau de masse est décalé d'une tension correspondant à la chute de tension aux bornes d'une diode polarisée en direct. Cette chute de tension V_{F} a une valeur typique de 0,7 volt. Par exemple, dans le cas d'une logique à deux états "0" et "1" de type TTL, le niveau logique "0" correspond à une tension inférieure à 0,4 volt et le niveau logique "1" correspond à une tension supérieure à 2 volts. Avec un décalage de 0,7 volt, le niveau "0" correspondant à la configuration représentée sur la figure 3 ne sera pas compatible avec le niveau "0" de la logique TTL.

Un deuxième inconvénient est dû à ce que la diode 42 est en fait réalisée par la jonction émetteur-base d'un transistor bipolaire parasite NPN dont le collecteur est constitué par les couches 11, 19 de type N, l'émetteur est constitué par la zone 41 et la base est constituée par le caisson 24, la base n'étant connectée à aucun élément à potentiel défini.

Ce transistor bipolaire parasite NPN à base flottante présente une mauvaise tenue en tension (une tenue en tension inférieure à celle du transistor MOS de puissance TP). Ainsi, dans la situation où le transistor MOS de puissance TP est à l'état bloqué, l'apparition d'une tension élevée aux bornes de la source de tension entraînera le claquage du transistor bipolaire parasite NPN avant celui du transistor MOS de puissance TP.

La présente invention propose une nouvelle structure qui permet de réaliser un dispositif de protection, ou diode active de protection, intégré à la partie logique. Selon l'invention, la diode active de protection contre des tensions inverses d'une partie logique comprise dans une structure monolithique qui comporte une partie logique et une partie de puissance de type à transistor MOS vertical et qui est connectée à une source de tension d'alimentation, la partie logique étant constituée de transistors MOS classiques situés dans un caisson d'un premier type de conductivité formé dans un substrat du deuxième type de conductivité, la face arrière du substrat correspondant au drain du transistor MOS vertical, ce caisson comprenant une surface supérieure, la diode active de protection étant réalisée dans ledit caisson, comprend un transistor MOS dont la grille est commandée par une tension dont le signe est représentatif de la polarité de la tension d'alimentation, dont la région de drain est connectée à la masse, et une zone profonde à dopage élevé du premier type de conductivité s'étendant à partir de la surface supérieure du caisson, cette zone étant reliée à la source du transistor MOS.

Ces objets, caractéristiques, et avantages ainsi que d'autres de la présente invention seront exposés plus en détail dans la description suivante d'un mode de réalisation particulier faite en relation avec les figures jointes parmi lesquelles :
la figure 1, déjà décrite, représente un schéma électrique comprenant une partie de commutation de puissance et une partie logique à protéger ;
la figure 2, déjà décrite, représente en coupe un exemple de structure mixte classique dans laquelle la partie de puissance est représentée de façon schématique sous forme d'une cellule d'un transistor MOS de puissance vertical de type diffusé (VDMOS) et la partie logique par un transistor MOS ;
la figure 3, déjà décrite, représente en coupe une structure dans laquelle une première façon de réaliser un dispositif de protection intégré à la partie logique est présentée ;
la figure 4 représente une vue en coupe de l'implantation d'une structure selon la présente invention dans laquelle un dispositif de protection est intégré à la partie logique ;
les figures 5A, 5B et 5C représentent des schémas électriques équivalents au dispositif de protection présenté sur la figure 4 ; et
la figure 6 représente un schéma électrique d'un système de commande du dispositif de protection de la partie logique.

De façon générale, comme cela est classique dans le domaine de la représentation des circuits intégrés, on notera que les diverses vues en coupe ne sont pas représentées à l'échelle ni d'une figure à l'autre, ni à l'intérieur d'une même figure, et notamment que les épaisseurs des couches sont dessinées arbitrairement dans le but de faciliter la lecture des figures.

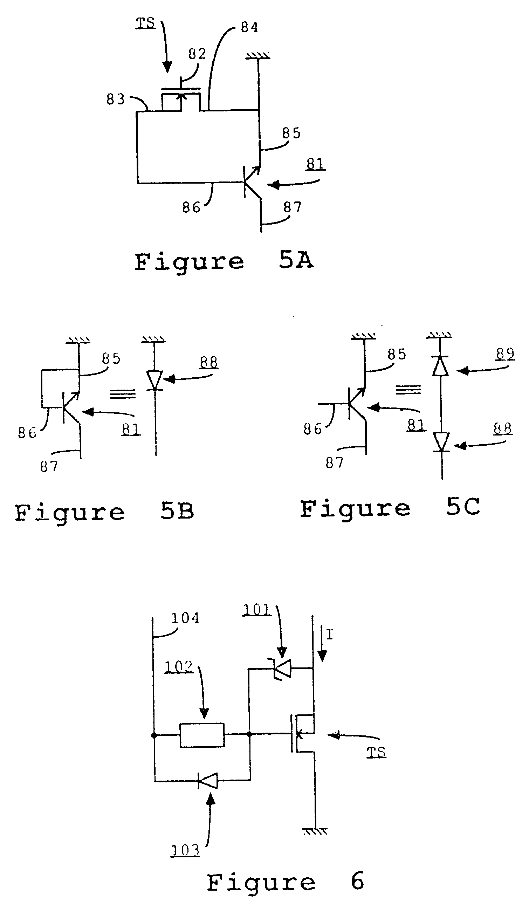

La figure 4 représente une vue en coupe de l'implantation dans un substrat 60, comprenant par ailleurs un transistor MOS vertical, d'une structure selon la présente invention. La face arrière du substrat 60 comprend une couche surdopée 73 revêtue d'une métallisation 74. Un transistor MOS classique TL-1 comprend une grille 61 formée par une couche de silicium polycristallin et des régions de source 62 et de drain 63 qui sont formées par une diffusion de type N⁺. Le transistor TL-1 est situé avec d'autres transistors d'un circuit de commande dans un caisson 64 de type P.

Un transistor MOS TS comprend une grille 65 formée par une couche de silicium polycristallin et des régions de source 66 et de drain 67 formées par une diffusion de type N⁺, ce transistor TS étant situé dans le même caisson 64 que le transistor TL-1. Une couche conductrice 68, réalisée par exemple en aluminium, est connectée à la région de drain 67 et permet la mise à la masse de cette région de drain.

Le caisson 64 présente une surface de caisson supérieure 69 et une surface de caisson inférieure 70 qui est située entre le caisson et le substrat 60. Une zone 71 à dopage élevé de type P⁺ est formée à partir de la surface de caisson supérieure et est connectée à la région de source 66 par une couche conductrice 72, réalisée par exemple en aluminium. Cette zone 71 peut s'étendre jusqu'à la surface de caisson inférieure 70 comme cela est représenté.

Dans cette structure apparaît un transistor bipolaire de type NPN dont l'émetteur est constitué par la région de drain 67 du transistor TS, la base par le caisson 64 et le collecteur par les couches 60, 73 de drain du transistor MOS vertical de puissance (voir figure 2).

Le transistor TS et le transistor bipolaire NPN constituent le dispositif de protection selon l'invention.

Les figures 5A, 5B et 5C représentent des schémas électriques équivalents au dispositif de protection présenté sur la figure 4. On désigne sur ces figures le transistor bipolaire NPN de la structure représentée sur la figure 4 par 81. La grille du transistor TS est désignée par 82, la source par 83 et le drain par 84. On désigne sur les figures 5A, 5B et 5C l'émetteur du transistor bipolaire NPN par 85, la base par 86 et le collecteur par 87.

Le transistor TS peut se trouver dans deux états suivant le signe de la tension appliquée sur sa grille.

Dans le cas où la tension appliquée sur sa grille est positive, le transistor TS est dans un état passant. Ce cas est représenté sur la figure 5B. La base 86 et l'émetteur 85 du transistor bipolaire 81 sont alors reliés. Le transistor bipolaire 81 est équivalent à une diode 88 qui est constituée, comme cela peut être observé sur la figure 4, par le caisson 64 et le substrat 60. Le caisson est alors au potentiel de la masse.

Dans le cas où la tension appliquée sur sa grille est négative, le transistor MOS TS est dans un état bloqué. Ce cas est représenté sur la figure 5C. La base 86 du transistor bipolaire n'est pas reliée à un potentiel défini. Le transistor bipolaire 81 est équivalent à deux diodes 88 et 89, la diode 88 étant constituée comme dans le cas de la figure 5B par le caisson 64 et le substrat 60, et la diode 89 étant constituée par le caisson 64 et la région de drain 67. La diode 89 permet la protection de la partie logique du circuit.

En appliquant une tension négative sur la grille du transistor TS seulement en cas d'inversion de polarité sur la borne de drain 74, on peut donc obtenir, ou bien une liaison du caisson à la masse quand la polarité est correcte, ou bien l'insertion d'une diode de protection pendant une inversion de polarité.

La figure 6 représente un schéma électrique d'un exemple de circuit de commande du dispositif de protection de la figure 4. Ce circuit de commande comprend une diode de type zener 101, reliée entre grille et source du transistor TS, une résistance 102 de valeur élevée (une valeur typique de la résistance 102 est 1 mégohm) et une diode 103 en parallèle, connectées entre la grille du transistor et une borne 104. La borne 104 est reliée au drain du transistor MOS de puissance, c'est-à-dire normalement à la borne positive de l'alimentation.

Si la tension appliquée sur la grille du transistor MOS TS est positive, le transistor TS est à l'état passant. La diode zener 101 permet de limiter la tension grille-source du transistor MOS TS. La partie logique consomme un courant I qui s'écoule à travers le transistor TS. Si l'on inverse la polarisation de la source de tension, la tension appliquée sur la grille du transistor TS est négative, le transistor est à l'état bloqué. On se retrouve dans le cas de la figure 5C où la diode 89 assure la protection de la partie logique.

Lorsqu'une inversion brutale de polarisation se produit alors que le circuit fonctionnait en régime continu avec une tension appliquée sur la grille du transistor MOS TS positive, il est nécessaire que le transistor TS soit mis à l'état bloqué très rapidement, afin que la protection de la partie logique soit assurée. Cette mise à l'état bloqué est rendue possible par la présence de la diode 103 qui permet une décharge très rapide de la grille du transistor TS.

Il est également nécessaire que le transistor TS ne soit remis à l'état passant qu'avec un certain retard après que la tension appliquée sur la grille du transistor TS ne soit redevenue positive. Cela permet de filtrer des oscillations de haute fréquence lorsque la tension d'alimentation est proche de 0 volt. Cela est réalisé avec la résistance 102 qui introduit une constante de temps de charge t de la grille du transistor TS. Avec une valeur de résistance de l'ordre de 1 mégohm, la constante de temps de charge t aura une valeur de l'ordre de 5 microsecondes.

## Revendications

1. Diode active de protection contre des tensions inverses d'une partie logique comprise dans une structure monolithique qui comporte une partie logique et une partie de puissance de type à transistor MOS vertical et qui est connectée à une source de tension d'alimentation et à la masse, la partie logique étant constituée de transistors MOS situés dans un caisson d'un premier type de conductivité formé dans un substrat semiconducteur du deuxième type de conductivité, la face arrière du substrat correspondant au drain du transistor MOS vertical, ce caisson comprenant une surface supérieure (69), la diode active de protection étant réalisée dans ledit caisson, caractérisée en ce qu'elle comprend :
- un transistor MOS dont la grille est commandée par une tension dont le signe est représentatif de la polarité de la tension d'alimentation, dont la région de drain est connectée à la masse, et
- une zone (71) profonde à dopage élevé du premier type de conductivité s'étendant à partir de la surface supérieure (69) du caisson, cette zone étant reliée à la source du transistor MOS.

2. Diode active de protection selon la revendication 1, caractérisée en ce que le transistor MOS a sa grille connectée à une résistance (102) et une diode (103) montées en parallèle entre ladite grille et une borne (104) reliée au drain du transistor MOS vertical.

3. Diode active de protection selon l'une des revendications 1 ou 2, caractérisée en ce qu'une diode zener (101) est reliée entre grille et source du transistor MOS.

## Claims

1. A protection active diode against reverse voltages of a logic portion integrated in a monolithic structure which comprises a logic portion and a power portion of the vertical MOS transistor type and which is connected to a supply voltage source and to ground, the logic portion being constituted by MOS transistors placed in a well of a first conductivity type formed in a semiconductor substrate of the second conductivity type, the rear surface of the substrate corresponding to the drain of the vertical MOS transistor, said well comprising an upper surface (69), the protection active diode being realized in said well, characterized in that it comprises:
- a MOS transistor, the gate of which is controlled by a voltage whose sign is representative of the supply voltage polarity, the drain region of which is grounded, and
- a highly doped deep area (71) of the first conductivity type extending from the upper surface (69) of the well, said area being connected to the source of the MOS transistor.

2. A protection active diode according to claim 1, characterized in that the MOS transistor has its gate connected to a resistor (102) and a diode (103) connected in parallel between said gate and a terminal (104) coupled to the drain of the vertical MOS transistor.

3. A protection active diode according to claim 1 or 2, characterized in that a zener diode (101) is connected between the gate and source of the MOS transistor.

## Patentansprüche

1. Aktive Schutzdiode gegen Rückwärtsspannungen einer logischen Teilschaltung, die in einer monolithischen Struktur enthalten ist, welche eine logische Teilschaltung und einen Leistungsteil mit vertikalen MOS-Transistoren aufweist und mit einer Versorgungsspannunngsquelle sowie mit Masse verbunden ist, wobei die logische Teilschaltung aus MOS-Transistoren aufgebaut ist, die in einem Graben eines ersten Leitungstyps in einem Halbleitersubstrat eines zweiten Leitungstyps gelegen sind, wobei die Rückseite des Substrates der Drain-Elektrode des vertikalen MOS-Transistors entspricht, der Graben eine Oberseite (69) aufweist und die aktive Schutzdiode in dem Graben realisiert ist, dadurch gekennzeichnet, daß sie folgende Merkmale aufweist:
- einen MOS-Transistor, dessen Steuerelektrode durch eine Spannung angesteuert wird, deren Vorzeichen repräsentativ für die Versorgungsspannung ist, und dessen Drainbereich mit Masse verbunden ist, und
- eine tiefe Zone (71) mit hoher Dotierung des ersten Leitungstyps, die sich von der Oberseite (69) des Grabens nach unten erstreckt und mit der Source-Elektrode des MOS-Transistors vrbunden ist.

2. Aktive Schutzdiode nach Anspruch 1, dadurch gekennzeichnet, daß die Steurelektrode des MOS-Transistors mit einem Widerstand (102) und einer Diode (103) verbunden ist, die in Parallelschaltung zwischen der Steuerelektrode und einem Anschluß (104) angeordnet sind, der mit der Drain-Elektrode des vertikalen MOS-Transistors verbunden ist.

3. Aktive Schutzdiode nach einem der Ansprüche 1 oder 2, dadurch gekennzeichnet, daß eine Zenerdiode (101) zwischen Steuerelektrode und Source-Elektrode des MOS-Transistors geschaltet ist.
